# EUROPÄISCHE PATENTSCHRIFT

(11) **EP 1 458 654 B1**
(45) Veröffentlichungstag und Bekanntmachung des Hinweises auf die Patenterteilung: **13.02.2008**
(21) Anmeldenummer: 02799062.1
(22) Anmeldetag: 19.12.2002
(51) Int. Cl.: C03C 17/00

(54) **VERFAHREN ZUR ERZEUGUNG LOKAL FUNKTIONELLER PHOTOKATALYTISCHER BEREICHE UND DAMIT ERHÄLTLICHE GEGENSTÄNDE**
METHOD FOR THE PRODUCTION OF LOCALLY FUNCTIONAL AREAS AND OBJECTS OBTAINED THEREWITH
PROCEDE DE PRODUCTION DE ZONES LOCALEMENT FONCTIONNELLES ET ARTICLES PRODUITS A PARTIR DE CELUI-CI

(30) Priorität: 19.12.2001 DE 10162681
(43) Veröffentlichungstag der Anmeldung: 22.09.2004
(73) Patentinhaber: Fraunhofer-Gesellschaft zur Förderung der angewandten Forschung e.V., 80686 München (DE)
(72) Erfinder: VERGÖHL, Michael, 38162 Destedt (DE); NEUMANN, Frank, 38100 Braunschweig (DE); THOMAS, Michael, 31275 Lehrte (DE); HUNSCHE, Berno, 38106 Braunschweig (DE); RICKERS, Christoph, 38124 Braunschweig (DE)
(74) Vertreter: Einsel, Martin
(86) Internationale Anmeldenummer: PCT/EP2002/014564
(87) Internationale Veröffentlichungsnummer: WO 2003/051787

(56) Entgegenhaltungen:
- US-A1- 2003 003 304
- PATENT ABSTRACTS OF JAPAN vol. 1998, no. 08, 30. Juni 1998 (1998-06-30) & JP 10 072664 A (BRIDGESTONE CORP), 17. März 1998 (1998-03-17)
- PATENT ABSTRACTS OF JAPAN vol. 1998, no. 09, 31. Juli 1998 (1998-07-31) & JP 10 086258 A (NITTO DENKO CORP), 7. April 1998 (1998-04-07)
- "Light-Induced amphiphilic surfaces" NATURE, Bd. 388, Nr. 31, Seiten 431-432, XP001094898
- SHIMIZU ET AL. : "Low-temperature synthesis of anatase thin films on glass and organic substrates by direct deposition from aqueous solutions" THIN SOLID FILMS, Bd. 351, Seiten 220-224, XP002244558

## Beschreibung

Die vorliegende Erfindung betrifft ein Verfahren zur Erzeugung lokal funktioneller Bereiche in Schichten oder Oberflächen, wobei diese Bereiche photokatalytische Aktivität aufweisen. Insbesondere betrifft die vorliegende Erfindung ein Verfahren zur Erzeugung von Bereichen wie Strukturen in Schichten bzw. Oberflächen, die Eigenschaften aufweisen wie photoinduzierbare Hydrophilie und die Fähigkeit, organische Substanzen abzubauen.

In jüngster Zeit haben selbstreinigende Oberflächen auf der Basis hydrophiler Beschichtungen an Bedeutung gewonnen. Es ist bekannt, dass das Material Titandioxid, TiO₂, in kristalliner Modifikation photokatalytische Aktivität aufweist. Die photokatalytische Aktivität führt dazu, dass die Oberfläche des Materials bei Bestrahlung mit Licht geeigneter Energie hydrophil, das heißt wasseranziehend, wird.

Das eingestrahlte Licht muss hierbei eine Photonenergie aufweisen, die größer ist als die Bandlücke des Materials. Die Bandlücke von Titandioxid beträgt ca. 3,4 eV entsprechend einer Wellenlänge von etwa 360 nm, so dass die photokatalytische Aktivität durch Bestrahlung mit UV-Licht induziert werden kann. Damit wird eine selbstreinigende Wirkung unter Wassereinfluss möglich.

Dieser Effekt kann ausgenutzt werden, um selbstreinigende Oberflächen zu erzeugen. Hierzu werden auf die gewünschten Substrate dünne Titandioxidschichten aufgebracht.

In "light-induced amphiphilic surface" Nature, Band 388, Juli 1997, Seite 431 und 432 werden die lichtinduzierten amphiphilen Eigenschaften von Oberflächen aus Titandioxid beschrieben.
Untersucht wurde ein Glassubstrat, auf dem eine dünne polykristalline Titandioxidschicht durch Auftragen eines Sols mit Titandioxid in der Anatasmodifikation erzeugt worden ist. Es wurde gefunden, dass die Schicht bei Bestrahlung mit UV-Licht sowohl hydrophile als auch oleophile Bereiche aufwies. Auf Grund dieser Eigenschaften wurde vorgeschlagen, derartige Beschichtungen zur Herstellung von selbstreinigenden Oberflächen zu verwenden, die die Fähigkeit aufweisen sowohl hydrophile als auch oleophile Verunreinigungen selbständig zu beseitigen.

J.-M. Herrmann et al. befasst sich in "Characterization and photocatalytic activity in aqueous medium of TiO2 and Ag-TiO2 coatings on quartz" Applied Catalysis B: Environmental 13 (1997) 219 bis 228, mit der photoinduzierbaren Hydrophilie von Titandioxidschichten mit und ohne Zusatz von Silber. Hierzu wurden mittels an sich bekannter Tauchbeschichtungsverfahren auf Quarzsubstraten Titandioxidschichten bzw. silberhaltige Titandioxidschichten aufgebracht. Titandioxid lag in diesen Schichten ebenfalls in der Anatasmodifikation vor.
Es wird beschrieben, dass die Schichten eine selbstreinigende Wirkung für anorganische und organische Verunreinigungen in Wasser aufweisen. So wurde beispielhaft gezeigt, dass die Schichten nach photokatalytischer Aktivierung Maleinsäure abbauen können.

JP 10 072 664 beschreibt Körper, die mit einer fotokatalytisch aktiven TiO₂-Schicht beschichtet sind, wobei die Abscheidung der fotokatalytisch aktiven TiO₂-Schicht mittels reaktiven Sputtern erfolgt.

JP 10 086 258 beschreibt ein Laminat aus zwei Polytetrafluorethylen-Schichten, wobei eine Schicht TiO₂-Partikel mit deodorierender antibakterieller Wirkung enthält. Die Schichten werden mittels eines nasschemischen Prozesses erhalten, wobei die Struktur zur Ausbildung des Laminats und der zweiten Polytetrafluorethylen-Schicht, die TiO₂-Partikel enthält, gebrannt wird.

Die vorstehend genannten Fundstellen befassen sich mit Schichten, wobei die gesamte Schicht als solche photokatalytisch aktiv ist. Eine lokale Funktionalisierung dieser Schichten, indem ausgewählte Bereiche der Schichten in photokatalytisch aktiver Form vorliegen, ist nicht vorgesehen.

Es war Aufgabe der Erfindung, ein Verfahren zur Verfügung zu stellen, mit dem titandioxidhaltige Schichten lokal funktionalisiert werden können, wobei in der Schicht gezielt ausgewählte Bereiche photokatalytisch aktiviert werden, so dass diese Bereiche bei Bestrahlung mit Licht geeigneter Wellenlänge photokatalytische Aktivität wie Hydrophilie aufweisen.

Erfindungsgemäß wird diese Aufgabe gelöst durch ein Verfahren zur Erzeugung von photokatalytisch aktiven Strukturen in einer Schicht, wobei zunächst eine photokatalytisch inaktive titanoxidhaltige Schicht vorgesehen wird, und durch lokale Erhitzung in der Schicht in den Bereichen, die der lokalen Erhitzung ausgesetzt sind, ein Phasenübergang in eine photokatalytisch aktive Modifikation induziert wird.

Im Sinne der Erfindung bedeutet "photokatalytisch aktiv", dass durch Bestrahlung mit Licht geeigneter Wellenlänge die photokatalytische Aktivität induziert werden kann.
Im Gegensatz dazu zeigt die photokatalytisch inaktive Modifikation bei Bestrahlung mit Licht einer Wellenlänge, die in der photokatalytisch aktiven Modifikation die photokatalytische Aktivität induziert, im wesentlichen keine Änderungen der photo-induzierbaren Eigenschaften wie Hydrophilie und/oder der Fähigkeit, organische Substanzen abzubauen.

Weiter umfasst die Erfindung Gegenstände, die mit einer titanoxidhaltigen Schicht versehen sind, wobei die titanoxidhaltige Schicht photokatalytisch aktive Strukturen aufweist.

Erfindungsgemäß wird zunächst eine photokatalytisch inaktive titanoxidhaltige Schicht vorgesehen. Durch lokale Erhitzung einzelner Bereiche findet in diesen Bereichen ein Übergang von der photokatalytisch inaktiven zu einer photokatalytisch aktiven Modifikation statt.
Durch die lokale Erhitzung ist es möglich, in einer an sich photokatalytisch inaktiven Schicht photokatalytisch aktive Strukturen oder Muster zu erzeugen.
Selbstverständlich kann auf diese Art und Weise auch die gesamte Schicht in eine photokatalytisch aktive Form überführt werden.

Für die lokale Erhitzung ist insbesondere die Verwendung eines Lasers mit ausreichend hoher Intensität geeignet.

Die erfindungsgemäß erhaltenen photokatalytisch aktiven titanoxidhaltigen Schichten bzw. photokatalytisch aktiven Strukturen auf titanoxidhaltigen Schichten zeigen eine hohe photoinduzierbare Hydrophilie und/oder die photoinduzierbare Fähigkeit, organische Substanzen wie Bakterien oder Keime abzubauen. Die photokatalytisch aktiven Schichtbereiche zeigen damit auch eine photoinduzierbare antibakterielle und auch desinfizierende Wirkung.

Bei der photokatalytisch inaktiven Modifikation handelt es sich um ein amorphes bis nanokristallines Material, das durch lokale Erhitzung in eine kristalline Modifikation überführt wird, wobei die kristalline Modifikation photokatalytisch aktiv ist.
Bei der photokatalytisch aktiven Modifikation handelt es sich folglich um ein Material, das nicht amorph bzw. nicht nanokristallin ist. Die photokatalytisch aktive Modifikation kann ein polykristallines bis kristallines Material sein.

Beispielsweise wurde für eine Kristallitgröße von 30 nm oder weniger keine photokatalytische Aktivität gefunden, so dass Schichten aus Kristalliten mit einer Größe von 30 nm oder weniger für die vorliegende Erfindung als nanokristallin anzusehen sind.

Nachdem erfindungsgemäßen Verfahren wird zunächst eine titanoxidhaltige Schicht erzeugt, die photokatalytisch inaktiv ist.
Die Schicht kann hierzu auf einem Substrat aufgebracht werden.

Die Schicht besteht vorzugsweise ganz oder teilweise aus Titandioxid in seiner photokatalytisch inaktiven Modifikation.
Hierbei liegt Titandioxid in einer amorphen bis nanokristallinen Form vor. Erst durch Übergang in eine im Wesentlichen kristalline Form zeigt sich die photokatalytische Aktivität des Titandioxids. Die kristalline Form kann eine polykristalline bis einkristalline Form sein.

Erfindungsgemäß bevorzugt liegt Titandioxid in der photokatalytisch aktiven Form in Rutil- oder Anatasmodifikation vor, wobei insbesondere die Anatasmodifikation bevorzugt ist.

Die Bandkante und damit die spektrale Empfindlichkeit der Schicht kann durch Zusatz anderer Stoffe zu dem Titandioxid in der Beschichtung variiert werden. Geeignete Dotierungsmittel sind bevorzugt Metalle wie z. B. Li, Ge, Ga, Y, Nb, Ta, Fe, Pt, Ag, Zn, Al, In, Sb aber auch Nicht- oder Halbmetalle wie z. B. B, N oder P.

Auch können als Titanoxidhaltige Schicht Mischoxide von Titandioxid mit Oxiden der vorstehend aufgeführten Metalle wie z. B. TiO₂-Nb₂O₅, TiO₂-Fe₂O₃ oder Oxinitride wie TiOₓN_{y} mit insbesondere 1<x<1,9 und 0,05<y<0,4 und Kombinationen davon verwendet werden.

Darüber hinaus hat es sich für die gewünschte photokatalytische Aktivität als vorteilhaft erwiesen, wenn das photokatalytisch aktivierte Material hohe Porosität aufweist. Unter Porosität wird die Packungsdichte verstanden, die als Verhältnis Volumenanteil Schichtmaterial zu Volumenanteil Schichtmaterial einschließlich der Leerstellen definiert ist. Dies bedeutet im Fall von strukturierten kristallisierten Bereichen innerhalb einer Schicht, dass dieser Bereich eine Porosität von mindestens 5 % und vorzugsweise von 5 bis 70 % aufweisen sollte. Als besonders vorteilhaft hat es sich erwiesen, wenn die strukturierten kristallisierten Bereiche eine Porosität von 40 % und mehr aufweisen.

Prinzipiell kann ein beliebiges Substrat eingesetzt werden. Beispiele hierfür sind Glas, Metall, Keramik oder Kunststoff.
Das Substrat kann je nach Bedarf starr oder flexibel, transparent oder opak sein.

Die Beschichtung des Substrats mit der photokatalytisch inaktiven titanoxidhaltigen Schicht kann nach einem beliebigen, hierfür an sich bekannten Verfahren erfolgen. Geeignete Beschichtungsverfahren sind z. B. Vakuumbeschichtungsverfahren, wie das reaktive oder nichtreaktive Magnetronsputtern, bzw. thermisches oder Elektronenstrahl- unterstütztes Aufdampfen. Weitere Beispiele sind das plasmaunterstützte Aufdampfen und Plasma-CVD-Verfahren. Vorzugsweise erfolgt die Beschichtung unter Bedingungen, bei denen die bevorzugte AnatasModifikation resultiert. Für das reaktive Magnetron-Sputtern haben sich hierfür höhere Temperaturen zwischen 100 und 250 °C als hilfreich erwiesen.

Die Schichtdicke ist nicht weiter kritisch und kann je nach Anwendung gewählt werden.
Geeignete Schichtdicken liegen in einem Bereich von 10 nm bis 10 µm, insbesondere von 50 nm bis 1 µm.

Für den Einsatz als Oberfläche mit funktioneller Aktivität haben sich insbesondere dünne Schichten mit einer Schichtdicke von 100 nm bis 700 nm, insbesondere von 400 nm bzw. in einer Größenordnung von 400 nm erwiesen.

Durch Erhitzung mit Energie hoher Intensität kann die photokatalytisch inaktive titanoxidhaltige Schicht oder Schichtbereiche in eine Modifikation überführt werden, die photokatalytisch aktiv ist. Hierbei werden die im wesentlichen amorphe bis nanokristalline Schicht oder Schichtbereiche in eine nicht amorphe und nicht nanokristalline polykristalline Schicht oder Schichtbereiche überführt.

Die lokale Erhitzung zur Erzeugung von Strukturen kann vorteilhaft mit einem Laser mit ausreichend hoher Intensität erfolgen, wobei durch Einwirkung des Lasers lokal eine Kristallisation der Beschichtung bewirkt wird. Um eine starke Absorption des Laserlichts zu erhalten sollte die Photonenenergie höher gewählt werden als die Bandlücke des Schichtmaterials.

Die minimalen geometrischen Abmessungen der erhaltenen Strukturen ergeben sich aus dem Beugungslimit des Lichts. So können z. B. mit einem Laser mit einer Wellenlänge von 354 nm Strukturen in einer Größenordnung von 500 nm erhalten werden. Beispielsweise kann hierfür ein frequenzverdreifachter Nd:YAG-Laser eingesetzt werden.

Kleinere Strukturen lassen sich beispielsweise durch die Verwendung von üblichen kurzwelligen Lasern, z. B. mit einer Wellenlänge von 193 nm oder 157 nm, erhalten.

Durch die lokale Kristallisation entstehen in der Schicht Bereiche, die photokatalytisch aktiv sind und eine hohe photoinduzierte Hydrophilie und/oder die photoinduzierte Fähigkeit aufweisen, organische Stoffe wie biologische Substanzen abzubauen, so dass die Strukturen auch eine antibakterielle Wirkung aufweisen.

Durch Einstellung der Laserparameter, wie Pulsdauer, Energie, Leistungsdichte kann das Ausmaß der Kristallisation und die Korngröße der erhaltenen Kristalle beeinflusst werden.

Durch entsprechende Einstellung der Laserparameter kann somit die bevorzugte Anatasmodifikation in einer gewünschten Korngröße erhalten werden.

Für die vorliegende Erfindung geeignete typische Werte für einen Laser sind für die Pulsdauer einige Nanosekunden bis zu kontinuierlicher Pulsdauer (cw) und für die Leistungsdichte von 0,01 bis 20 W/mm².
Aus dem gewählten Fokus und der Leistungsdichte des Lasers ergibt sich die Energie des Lasers. Beispielsweise kann eine Energie von 100 mW mit einem Laserfokus von 10 µm und einer typischen Leistungsdichte von 1 W/mm² erhalten werden.

Durch das erfindungsgemäße Verfahren lassen sich in einer photokatalytisch inaktiven titanoxidhaltigen, insbesondere titandioxidhaltigen Schicht beliebige photokatalytisch aktivierte Strukturen vorsehen. Die Strukturen können periodische oder nichtperiodische Muster bilden. Auch die Größenabmessung der Strukturen ist nicht weiter kritisch und kann von wenigen 10 nm bis hin zu mehreren mm betragen. Wie vorstehend ausgeführt, ist die erhältliche Mindestgröße der Struktur allein durch die apparativen Möglichkeiten wie der Wellenlänge des Lasers bedingt und der Fokussierung des Laserstrahls.

Die Aktivierung der erhaltenen Struktur und damit der kristallisierten Bereiche erfolgt durch Bestrahlung mit Licht eine geeignete Wellenlänge, dessen Photonenergie größer als die Bandlücke des Titanoxidsmaterials der strukturierten kristallisierten Bereiche ist. Die erforderliche Energie variiert für das Titanoxid-Material je nach Oxidationszahl, z. B. im Fall von Oxinitrid, Kristallmodifikation, Dotierungsgrad etc. So hat Titandioxid eine Bandlücke von ca. 3,4 eV entsprechend ca. 360 nm, so dass zur Aktivierung UV-Licht eingesetzt werden kann, dessen Photonenergie größer als die Bandlücke von Titandioxid ist.

Die strukturierten Bereiche können durch eine ganzflächige homogene Beleuchtung mit Licht, welches Licht mit Anteilen enthält, bei denen die Photonenergie größer als die Bandlücke des Materials ist, wie z. B. Sonnenlicht, Licht an der Schwarzlichtlampe, Xenonlampe und Halogenlicht, aktiviert werden.

Es hat sich gezeigt, dass der Effekt der photoinduzierten Hydrophilie bzw. die photoinduzierte antibakterielle Wirkung im allgemeinen bei Dunkelheit abnimmt. Durch Bestrahlung mit Licht, wie es vorstehend genannt worden ist, kann dieser Effekt jedoch aufgefrischt werden, so dass dann wieder die strukturierten aktivierten Bereiche entstehen.

Die vorliegende Erfindung eignet sich insbesondere für Anwendungen, für die Strukturen mit einer hohen photoinduzierten Hydrophilie und/oder photoinduzierten antibakteriellen, sterilen Wirkung vorteilhaft sind. Beispielhaft sei hier das so genannte "Spottingverfahren" in der Biotechnologie genannt.

Mit dem erfindungsgemäßen Verfahren können Gegenstände erhalten werden, die eine titanoxidhaltige Schicht oder Oberfläche aufweisen, in der photokatalytisch aktivierte Strukturen erzeugt worden sind. Die titanoxidhaltige Schicht oder Oberfläche weist damit photokatalytisch aktive Bereiche neben photokatalytisch inaktiven Bereichen auf.

Die Schicht besteht vorzugsweise ganz oder teilweise aus Titandioxid. Die photokatalytisch aktivierten Bereiche liegen hierbei vorzugsweise in der Anatasmodifikation vor.

Damit umfasst die Erfindung auch Anwendungen, wobei auf einem Substrat eine titanoxidhaltige Schicht vorgesehen ist, die kristallisierte Bereiche mit photokatalytischer Aktivität aufweist.

## Patentansprüche

1. Verfahren zur Erzeugung von photokatalytisch aktiven Strukturen in einer titanoxidhaltigen Schicht,
**dadurch gekennzeichnet,**
**dass** das Verfahren folgende Schritte umfasst
- Vorsehen einer photokatalytisch inaktiven titanoxidhaltigen Schicht,
- Umwandlung der Schicht oder ausgewählter Bereiche davon in eine photokatalytisch aktive Modifikation durch lokale Erhitzung, wobei in der Schicht bzw. den Bereichen der Schicht, die einer lokalen Erhitzung unterzogen werden, ein Übergang von einer photokatalytisch inaktiven Form in eine photokatalytisch aktive Modifikation erfolgt, und die photokatalytisch aktiven Bereiche photoinduzierte Hydrophilie und/oder die photoinduzierte Fähigkeit aufweisen, organische Stoffe abzubauen.

2. Verfahren nach Anspruch 1,
**dadurch gekennzeichnet,**
**dass** die lokale Erhitzung mittels Laser erfolgt.

3. Verfahren nach Anspruch 1 oder 2,
**dadurch gekennzeichnet,**
**dass** die Schicht ganz oder teilweise aus Titandioxid besteht.

4. Verfahren nach Anspruch 3,
**dadurch gekennzeichnet,**
**dass** das Titandioxid in den photokatalytisch aktivierten Bereichen in der Anatasmodifikation vorliegt.

5. Verfahren nach einem der vorhergehenden Ansprüche,
**dadurch gekennzeichnet,**
**dass** die titanoxidhaltige Schicht zusätzlich Dotierungsmittel enthält.

6. Verfahren nach Anspruch 5,
**dadurch gekennzeichnet,**
**dass** das Dotierungsmittel ausgewählt ist unter Li, Ge, Ga, Y, Nb, Ta, Fe, Pt, Ag, Zn, Al, In, Sb, B, N und P.

7. Verfahren nach einem der Ansprüche 1, 2, 5 oder 6,
**dadurch gekennzeichnet,**
**dass** die titanoxidhaltige Schicht ein Mischoxid mit Titandioxid, ein Titanoxinitrid oder eine Kombination davon ist.

8. Verfahren nach Anspruch 6,
**dadurch gekennzeichnet,**
**dass** die titanoxidhaltige Schicht ausgewählt ist unter TiO₂-Nb₂O₅. TiO₂.-Fe₂O₃ oder TiOₓN_{y} mit 1 <x<1,9 und 0,05<y<0,4 und Kombinationen davon.

9. Verfahren nach einem der vorhergehenden Ansprüche,
**dadurch gekennzeichnet,**
**dass** die Bereiche der titanoxidhaltigen Schicht, die einer lokalen Erhitzung unterzogen werden, in eine nicht amorphe und nicht nanokristalline Modifikation überführt werden.

10. Verfahren nach Anspruch 9,
**dadurch gekennzeichnet,**
**dass** die nicht amorphe und nicht nanokristalline Modifikation eine polykristalline Modifikation ist.

11. Verfahren nach einem der vorhergehenden Ansprüche,
**dadurch gekennzeichnet,**
**dass** die titanoxidhaltige Schicht auf einem Substrat ausgewählt unter Glas, Kunststoff oder Metall vorgesehen ist.

12. Anordnung mit photokatalytisch strukturierter Oberfläche,
**dadurch gekennzeichnet,**
**dass** die Anordnung ein Substrat umfasst, auf dem eine titanoxidhaltige Schicht vorgesehen ist, wobei die titanoxidhaltige Schicht photokatalytisch aktive und photokatalytisch inaktive Bereiche aufweist.

13. Verwendung einer titanoxidhaltigen Schicht mit photokatalytisch aktiven Bereichen erhältlich nach einem der Ansprüche 1 bis 11 oder einer Anordnung nach Anspruch 12 als Schicht oder Anordnung mit einer photoinduzierten antibakteriellen Wirkung.

14. Verwendung nach Anspruch 13,
**dadurch gekennzeichnet,**
**dass** die Schicht mit photokatalytisch aktivierten Bereichen oder die Anordnung gemäß Anspruch 12 in einem Spottingverfahren eingesetzt wird.

## Claims

1. Method for the production of photocatalytically active structures in a layer containing titanium oxide,
**characterised in**
**that** the method comprises the following steps
- providing a photocatalytically inactive titanium-oxide-containing layer,
- converting the layer or selected areas thereof to a photocatalytically active modification through local heating, wherein a transition from a photocatalytically inactive form to a photocatalytically active modification takes place in the layer or the areas of the layer which are subjected to local heating, and the photocatalytically active areas exhibit photoinduced hydrophilicity and/or have the photoinduced capability to degrade organic substances.

2. Method according to Claim 1,
**characterised in**
**that** the local heating takes place by means of laser.

3. Method according to Claim 1 or 2,
**characterised in**
**that** the layer consists completely or partly of titanium dioxide.

4. Method according to Claim 3,
**characterised in**
**that** the titanium dioxide is present in the anatase modification in the photocatalytically active areas.

5. Method according to any one of the preceding Claims,
**characterised in**
**that** the titanium-oxide-containing layer additionally comprises doping agent.

6. Method according to Claim 5,
**characterised in**
**that** the doping agent is selected from Li, Ge, Ga, Y, Nb, Ta, Fe, Pt, Ag, Zn, Al, In, Sb, B, N and P.

7. Method according to any one of Claims 1, 2, 5 or 6,
**characterised in**
**that** the titanium-oxide-containing layer is a mixed oxide with titanium dioxide, a titanium oxinitride or a combination thereof.

8. Method according to Claim 6,
**characterised in**
**that** the titanium-oxide-containing layer is selected from TiO₂-Nb₂O₅, TiO₂-Fe₂O₃ or TiOₓN_{y} with 1<x<1.9 and 0.05<y<0.4 and combinations thereof.

9. Method according to any one of the preceding Claims,
**characterised in**
**that** the areas of the titanium-oxide-containing layer which are subjected to local heating are converted to a non-amorphous and non-nanocrystalline modification.

10. Method according to Claim 9,
**characterised in**
**that** the non-amorphous and non-nanocrystalline modification is a polycrystalline modification.

11. Method according to any one of the preceding Claims,
**characterised in**
**that** the titanium-oxide-containing layer is provided on a substrate selected from glass, a plastics material or metal.

12. Arrangement with a photocatalytically structured surface,
**characterised in**
**that** the arrangement comprises a substrate on which a titanium-oxide-containing layer is provided, wherein the titanium-oxide-containing layer has photocatalytically active and photocatalytically inactive areas.

13. Use of a titanium-oxide-containing layer and having photocatalytically active areas obtainable according to any one of Claims 1 to 11 or an arrangement according to Claim 12 as a layer or an arrangement with a photoinduced antibacterial effect.

14. Use according to Claim 13,
**characterised in**
**that** the layer with photocatalytically activated areas or the arrangement according to Claim 12 is used in a spotting method.

## Revendications

1. Procédé pour la fabrication de structures actives par photocatalyse dans une couche comportant de l'oxyde de titane,
**caractérisé en ce**
**que** le procédé comporte les étapes suivantes consistant à :
- prévoir une couche inactive par photocatalyse comportant de l'oxyde de titane
- transformer, par chauffage local, la couche ou des zones choisies de celle-ci en une forme active par photocatalyse, une transition de la forme inactive par photocatalyse en une forme active par photocatalyse se produisant dans la couche et/ou dans les zones de la couche, qui sont soumises à un réchauffement local, et les parties actives par photocatalyse présentant une hydrophilie photo-induite et/ou la capacité photo-induite de dégrader des matières organiques.

2. Procédé selon la revendication 1,
**caractérisé en ce**
**que** le chauffage local est effectué à l'aide d'un laser.

3. Procédé selon la revendication 1 ou la revendication 2,
**caractérisé en ce**
**que** la couche se compose totalement ou partiellement d'oxyde de titane.

4. Procédé selon la revendication 3,
**caractérisé en ce**
**que** l'oxyde de titane dans les zones activées par photocatalyse se présente sous la forme anatase.

5. Procédé selon l'une quelconque des revendications précédentes,
**caractérisé en ce**
**que** la couche comprenant de l'oxyde de titane contient en plus des dopants.

6. Procédé selon la revendication 5,
**caractérisé en ce**
**que** le dopant est choisi parmi Li, Ge, Ga, Y, Nb, Ta, Fe, Pt, Ag, Zn, Al, In, Sb, B, N et P.

7. Procédé selon l'une quelconque des revendications 1, 2, 5 ou 6,
**caractérisé en ce**
**que** la couche contenant de l'oxyde de titane est un mélange d'oxydes avec du dioxyde de titane, un oxynitrure de titane ou une combinaison de ces derniers.

8. Procédé selon la revendication 6,
**caractérisé en ce**
**que** la couche contenant l'oxyde de titane est choisie parmi TiO₂-Nb₂O₅, TiO₂-Fe₂O₃ ou TiOₓN_{y} avec 1<x<1,9 et 0,05<y<0,4 et des combinaisons de ces derniers.

9. Procédé selon l'une quelconque des revendications précédentes,
**caractérisé en ce**
**que** les zones de la couche contenant de l'oxyde de titane, qui sont soumises à un chauffage local, sont converties en une forme non amorphe et non nanocristalline.

10. Procédé selon la revendication 9,
**caractérisé en ce**
**que** la forme non amorphe et non nanocristalline est une forme poly-cristalline.

11. Procédé selon l'une quelconque des revendications précédentes,
**caractérisé en ce**
**que** la couche contenant l'oxyde de titane est prévue sur un substrat choisi parmi le verre, une matière synthétique ou du métal.

12. Arrangement avec une surface structurée par photocatalyse,
**caractérisé en ce**
**que** l'arrangement comporte un substrat, sur lequel est prévue une couche contenant de l'oxyde de titane, la couche contenant de l'oxyde de titane présentant des parties actives par photocatalyse et inactives par photocatalyse.

13. Utilisation d'une couche contenant de l'oxyde de titane avec des parties actives par photocatalyse selon l'une quelconque des revendications 1 à 11 ou arrangement selon la revendication 12 sous forme de couche ou d'arrangement avec un effet antibactérien photo-induit.

14. Utilisation selon la revendication 13,
**caractérisée en ce**
**que** la couche avec les zones activées par photocatalyse ou l'arrangement selon la revendication 12 sont mis en oeuvre dans un procédé de spotting.
